(19) Europäisches Patentamt
European Patent Office
Office européen des brevets

(11) Veröffentlichungsnummer: **0 272 550 B1**

(12) **EUROPÄISCHE PATENTSCHRIFT**

(45) Veröffentlichungstag der Patentschrift: **12.08.92**

(51) Int. Cl.$^5$: **G03F 7/021**, G03F 7/095

(21) Anmeldenummer: **87118279.6**

(22) Anmeldetag: **10.12.87**

# (54) Lichtempfindliches Aufzeichnungsmaterial mit einer lichtempfindlichen Zwischenschicht.

(30) Priorität: **23.12.86 DE 3644160**

(43) Veröffentlichungstag der Anmeldung:
**29.06.88 Patentblatt 88/26**

(45) Bekanntmachung des Hinweises auf die Patenterteilung:
**12.08.92 Patentblatt 92/33**

(84) Benannte Vertragsstaaten:
**DE FR GB IT NL**

(56) Entgegenhaltungen:
**EP-A- 0 167 963**
**FR-A- 1 487 028**
**FR-A- 2 450 473**
**GB-A- 2 023 861**
**GB-A- 2 032 124**

(73) Patentinhaber: **HOECHST AKTIENGESELLSCHAFT**
**Postfach 80 03 20**
**W-6230 Frankfurt am Main 80(DE)**

(72) Erfinder: **Pawlowski, Georg, Dr.**
**Blücherstrasse 48**
**W-6200 Wiesbaden(DE)**
Erfinder: **Lehmann, Peter, Dr.**
**An der Ziegelei 12**
**W-6233 Kelkheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die Erfindung betrifft ein lichtempfindliches Aufzeichnungsmaterial mit einem Schichtträger und einer lichtempfindlichen Schicht, die im wesentlichen ein Diazoniumsalz-Polykondensationsprodukt, ein in Wasser unlösliches, in organischen Lösungen oder wäßrigalkalischen Lösungen lösliches, zumindest aber quellbares Bindemittel, einen unter Einwirkung von aktinischer Strahlung Radikale bildenden Polymerisationsinitiator und eine polymerisierbare, ethylenisch ungesättigte Verbindung mit mindestens einer ungesättigten Gruppe und einem Siedepunkt bei Normaldruck oberhalb von 100 °C enthält. Das daraus hergestellte Aufzeichnungsmaterial ist vorzugsweise zur Herstellung von Flachdruckplatten hoher Qualität geeignet.

Es ist bekannt, daß sich die lithographischen und drucktechnischen Eigenschaften von lichtempfindlichen Gemischen durch geeignete Kombinationen von lichtempfindlichen Schichten unterschiedlicher Zusammensetzung beeinflussen lassen.

So wird beispielsweise in der US-PS 3 905 815 ein lichtempfindliches Aufzeichnungsmaterial beschrieben, das auf einem geeigneten Trägermaterial zunächst eine sehr dünne Schicht einer Diazoniumsalz-Verbindung und darüber eine Schicht einer photopolymerisierbaren Verbindung aufweist. Durch diese Kombination soll das Auflösungsvermögen des Aufzeichnungsmaterials verbessert werden.

Eine ähnliche Kombination wird in der DE-OS 28 43 762 vorgeschlagen. Dabei wird eine Diazoniumsalz-Polykondensationsverbindung als Unterschicht verwendet, die wasserlöslich ist und die gleichzeitig als hydrophilisierende Zwischenschicht auf dem Träger fungieren soll. Auch hier wird eine Verbesserung des Auflösungsvermögens sowie eine verbesserte Lagerfähigkeit beschrieben.

Aus den DE-OS 20 24 244, 31 30 987, 30 36 077 und 34 04 366 sind lichtempfindliche Gemische - allerdings als Monoschichten - bekannt, die aus der Kombination eines Diazoniumsalz-Polykondensationsprodukts mit einem polymeren, in wäßrig-alkalischen Entwicklern löslichen oder zumindest quellbaren Bindemittel bestehen. Derartige Gemische zeigen sehr gute lithographische Eigenschaften, besitzen aber neben gewissen spezifischen den generellen und daher ausschlaggebenden Nachteil, daß ihre Lichtempfindlichkeit und insbesondere die Entwickelbarkeit bei höheren Schichtdicken drastisch abnehmen, so daß derartige Schichten im allgemeinen nur für mittlere Druckauflagen geeignet sind. Die erschwerte Entwickelbarkeit führt zudem zu einem erhöhten Entwicklerverbrauch.

Aus den DE-OS 23 61 931, 29 03 270, 30 07 212, 34 25 328 und der deutschen Patentanmeldung mit der Anmeldenummer P 35 28 309.2 sind lichtempfindliche Aufzeichnungsmaterialien bekannt, deren lichtempfindliche Schicht ein Diazoniumsalz-Polykondensationsprodukt, eine polymerisierbare Verbindung, einen Photoinitiator und ein polymeres Bindemittel enthält. Als Vorteile dieser Kombination werden eine verbesserte Auflösung, erhöhte erzielbare Druckauflagen und schnelle wäßrig-alkalische Entwickelbarkeit genannt. Nachteilig an diesen Gemischen ist jedoch ihre begrenzte Lagerfähigkeit.

Es war daher die Aufgabe der Erfindung, ein lichtempfindliches Aufzeichnungsmaterial bereitzustellen, das unter Beibehaltung der bekannt guten lithographischen Eigenschaften von Diazoniumsalz-haltigen Monoschichten eine deutlich höhere Druckauflage bei vergleichbarer Lichtempfindlichkeit ermöglicht, eine verbesserte Lagerstabilität erbringt sowie einen verringerten Entwicklerverbrauch aufweist.

Die Erfindung geht aus von einem lichtempfindlichen Aufzeichnungsmaterial der oben genannten Gattung, das dadurch gekennzeichnet ist, daß das Aufzeichnungsmaterial zwischen der lichtempfindlichen Schicht und dem Schichtträger eine lichtempfindliche Zwischenschicht enthält, die im wesentlichen ein Diazoniumsalz-Polykondensationsprodukt und ein in Wasser unlösliches, in organischen Lösungsmitteln lösliches und in wäßrigalkalischen Lösungen lösliches, zumindest aber quellbares polymeres Bindemittel enthält.

Überraschend wurde nun gefunden, daß sich die in der Aufgabenstellung beschriebenen Eigenschaften dann erzielen lassen, wenn man die in der Lösung beschriebene erfindungsgemäße Kombination zweier Schichten verwendet. Es war besonders überraschend, daß sich bei dieser Kombination auch verhältnismäßig dicke Schichten noch leicht und schleierfrei wäßrig-alkalisch entwickeln lassen und diese dennoch zu ihrer Aushärtung einer nur geringen Lichtmenge bedürfen. Die Abriebfestigkeit ist jedoch so hoch, daß sich höchste Auflagenleistungen erzielen lassen.

Ein weiterer Vorteil des erfindungsgemäßen lichtempfindlichen Aufzeichnungsmaterials ist, daß beide Schichten mit dem gleichen Entwicklersystem verarbeitbar sind. Bevorzugt wird ein Entwicklersystem auf rein wäßriger oder wäßrig-alkalischer Basis verwendet, welches gegebenenfalls geringe Mengen eines organischen Tensids oder eines hochsiedenden, nicht toxischen Lösungsmittels enthält.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen B, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-C 20 24 244 beschrieben.

Allgemein sind alle Diazoniumsalz-Polykondensationsprodukte geeignet, die in der DE-A 27 39 774 beschrieben sind.

Die Diazoniumsalzeinheiten A-$N_2$Q leiten sich bevorzugt von Verbindungen der Formel $(R^8\text{-}R^9\text{-})_pR^{10}\text{-}N_2Q$ ab, wobei

Q das Anion der Diazoniumverbindung,
p eine ganze Zahl von 1 bis 3,
$R^8$ einen aromatischen Rest mit mindestens einer zur Kondensation mit aktiver Carbonylverbindung befähigten Position,
$R^{10}$ eine Phenylengruppe,
$R^9$ eine Einfachbindung oder eine der Gruppen:

$-(CH_2)_q-NR^{11}-$,
$-O-(CH_2)_r-NR^{11}-$,
$-S-(CH_2)_r-NR^{11}-$,
$-S-CH_2CO-NR^{11}-$,
$-O-R^{12}-O-$,
- O -
- S -

oder

$-CO-NR^{11}-$

bedeuten, worin

q eine Zahl von 0 bis 5,
r eine Zahl von 2 bis 5,
$R^{11}$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^{12}$ eine Arylengruppe mit 6 bis 12 C-Atomen ist.

Von den genannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponenten B werden die gegebenenfalls substituierten Diphenylether, Diphenylsulfide, Diphenylmethane oder Diphenyle bevorzugt. Dabei werden für die Kondensation die Bis-methoxymethyl-, Bis-hydroxymethyl- oder Bis-acetoxymethylderivate der Grundkörper mit besonderem Vorteil eingesetzt. Das Kondensationsprodukt kann im Mittel 0,1 bis 50, bevorzugt 0,2 bis 20 Einheiten B je Einheit A-$N_2$Q enthalten.

Weitere besonders vorteilhafte Polykondensationsprodukte werden erhalten, indem ein ggf. substituiertes Diphenylamindiazoniumsalz zuerst mit einer aromatischen Verbindung $R^a\text{-}O\text{-}CH_2\text{-}R^b$ und danach mit einer aromatischen Verbindung $R^a\text{-}O\text{-}CH_2\text{-}R^c\text{-}CH_2\text{-}O\text{-}R^a$ kondensiert wird, wobei $R^a$ ein Wasserstoffatom, ein Alkyl- oder aliphatischer Acylrest, $R^b$ ein ggf. substituierter aromatischer Rest und $R^c$ der Rest eines aromatischen Kohlenwasserstoffs, eines Phenols, Phenolethers, aromatischen Thioethers, einer aromatischen heterocyclischen Verbindung oder eines organischen Säureamids ist. Diese Kondensationsprodukte sind in der EP-A 126 875 beschrieben.

Erfindungsgemäß enthält die Zwischenschicht im allgemeinen 5 bis 90, bevorzugt 10 bis 70 Gew.-% der Diazoniumverbindung. Die lichtempfindliche Schicht enthält im allgemeinen zwischen 5 bis 60, bevorzugt 10 bis 40 Gew.-% des Diazoniumsalz-Polykondensationsprodukts, bezogen auf den Gesamtgehalt der nichtflüchtigen Bestandteile. Je nach Art der Anwendung kann die verwendete Diazoniumsalzverbindung der Zwischenschicht mit der der lichtempfindlichen Schicht identisch sein oder verschieden.

Als Bindemittel können für die Zwischenschicht praktisch alle polymeren Bindemittel verwendet werden, die in Wasser unlöslich, in organischen Lösungsmitteln löslich und in wäßrig-alkalischen Lösungen löslich oder zumindest quellbar sind. Geeignete Bindemittel sind in zahlreichen Anmeldungen beschrieben.

Besonders erwähnt werden sollen Carboxylgruppen enthaltende Bindemittel, wie beispielsweise Copolymerisate aus (Meth)acrylsäure und deren ungesättigten Homologen, wie beispielsweise Crotonsäure oder ähnliche, Copolymerisate des Maleinsäureanhydrids oder seiner Halbester, Umsetzungsprodukte hydroxylgruppenhaltiger Polymere mit cyclischen Anhydriden von Dicarbonsäuren, sowie deren Mischungen.

Weiterhin sind geeignet Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Co-Polymere des Allylalkohols, Copolymere des Vinylalkohols, oder Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, mit aromatischen Phenolen oder Copolymerisate des Hydroxystyrols. Schließlich lassen sich auch Copolymerisate des (Meth)acrylsäureamids mit Alkyl(meth)acrylaten verwenden; derartige Polymere sind jedoch im allgemeinen nicht bevorzugt.

Die vorstehend beschriebenen Polymere sind insbesondere dann geeignet, wenn sie ein Molekulargewicht zwischen 500 und 200.000 oder darüber, bevorzugt 1.000 bis 100.000, aufweisen und entweder Säurezahlen zwischen 10 und 250, bevorzugt 20 und 150, oder Hydroxylzahlen zwischen 50 und 750, bevorzugt 100 und 600, aufweisen.

Als bevorzugte Bindemittelklassen seien nachstehend erwähnt:

Copolymerisate der (Meth)acrylsäure mit Alkyl(meth)acrylaten, (Meth)acrylsäurenitril oder dergleichen,
Copolymerisate der Crotonsäure mit Alkyl(meth)acrylaten, (Meth)acrylsäurenitril oder dergleichen,
Copolymerisate der Vinylessigsäure mit Alkyl(meth)acrylaten,
Copolymerisate des Maleinsäureanhydrids mit ggf. substituierten Styrolen,
Copolymerisate des Maleinsäureanhydrids mit ungesättigten Kohlenwasserstoffen,
Copolymerisate des Maleinsäureanhydrids mit ungesättigten Ethern,
Copolymerisate des Maleinsäureanhydrids mit ungesättigten Estern,
Veresterungsprodukte der Copolymerisate des Maleinsäureanhydrids,
Veresterungsprodukte von Hydroxylgruppen enthaltenden Polymeren mit den cyclischen Anhydriden von aliphatischen, gesättigten oder ungesättigten, aromatischen oder heteroaromatischen Di- oder Polycarbonsäuren,
Umsetzungsprodukte aus Hydroxylgruppen enthaltenden Polymeren mit aliphatischen, gesättigten oder ungesättigten oder aromatischen Sulfonylisocyanaten,
Umsetzungsprodukte von Hydroxylgruppen enthaltenden Polymeren mit aliphatischen, gesättigten oder ungesättigten oder aromatischen Phosphinsäureisocyanaten,
Copolymerisate des Hydroxyalkyl(meth)acrylats mit Alkylmethacrylaten, Methacrylsäurenitril oder dergleichen,
Copolymerisate des Allylalkohols mit ggf. substituierten Styrolen,
Copolymerisate des Vinylalkohols mit Alkyl(meth)acrylaten oder anderen polymerisationsfähigen ungesättigten Verbindungen,
Polyurethane, sofern sie eine ausreichende Anzahl freier OH-Gruppen aufweisen,
Epoxyharze,
Polyester,
teilverseifte Polyvinylacetat-Copolymere,
Polyvinylacetale mit freien OH-Gruppen,
Copolymerisate des Hydroxystyrols mit Alkyl(meth)acrylaten oder dergleichen,
Phenol-Formaldehyd-Harze, wie beispielsweise Novolake und ähnliche mehr.

Bevorzugt werden unter diesen die Copolymerisate der (Meth)acrylsäure mit Alkyl(meth)acrylaten und/oder (Meth)acrylsäurenitril, die Copolymerisate des Maleinsäureanhydrids und dessen Veresterungsprodukte, die Veresterungsprodukte von Hydroxylgruppen enthaltenden Polymeren mit den cyclischen Anhydriden von Di- oder Polycarbonsäuren, Copolymerisate des Hydroxyalkyl(meth)acrylats mit Alkyl(meth)-acrylaten und/oder (Meth)acrylsäurenitril und (Meth)acrylsäure, Copolymerisate des Vinylalkohols, insbesondere teilverseifte Polyvinylacetat-Copolymere oder Polyvinylacetale oder Polyurethane.

Besonders bevorzugt werden unter diesen polymeren Verbindungsklassen jene Polymere, die sich vom Polyvinylalkohol ableiten lassen. Derartige Polymere sind insbesondere in der DE-OS 34 04 366 und in der nicht veröffentlichten EP-Patentanmeldung mit der Anmeldenummer 86 110 604.5 beschrieben.

Unter diesen seien die Bindemittel, die in der DE-OS 34 04 366 beschrieben sind, besonders herausgestellt. Die zur Herstellung der Bindemittel eingesetzten Säureanhydride leiten sich bevorzugt von einer Di- oder Tricarbonsäure, insbesondere einer Dicarbonsäure ab, und können ein, zwei oder mehrere Ringe enthalten.

Besonders bevorzugte Bindemittel werden durch Umsetzen mit Säureanhydriden einer der Formeln I, II oder III

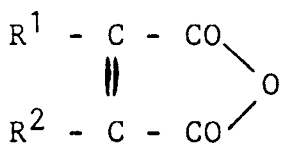 (I)

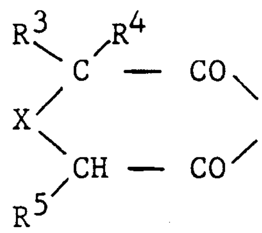 (II)

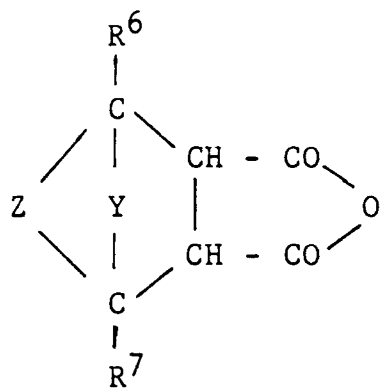 (III)

erhalten, worin

$R^1$ und $R^2$ einzeln Wasserstoffatome, Alkylgruppen oder Halogen bedeuten oder miteinander zu einem aromatischen oder heteroaromatischen, gegebenenfalls substituierten und ggf. teilweise hydrierten 5- oder 6-gliedrigen Ring verbunden sind, an den bis zu zwei aromatische oder cyclo-aliphatische Ringe ankondensiert sein können,

$R^3$, $R^4$ und $R^5$ einzeln Wasserstoffatome oder Alkylgruppen bedeuten
oder

$R^3$ und $R^5$ miteinander zu einem ggf. substituierten gesättigten oder ungesättigten aliphatischen Ring verbunden sind, der einschließlich X fünf oder sechs Ringglieder haben kann,

$R^6$ und $R^7$ Wasserstoffatome oder Alkylgruppen,

X eine Einfachbindung, eine 1,1-Alkylengruppe, eine 1,1-Cycloalkylengruppe, die ggf. substituiert sind, ein Sauerstoff- oder Schwefelatom,

Y ein Sauerstoff- oder Schwefelatom, eine 1,1- oder 1,2-Alkylengruppe oder eine 1,2-Alkenylengruppe, an die ggf. ein aromatischer oder cycloaliphatischer Ring ankondensiert ist, und

Z die zur Vervollständigung eines gesättigten oder ungesättigten ggf. substituierten Rings erforderlichen Ringglieder bedeuten, wobei an diesen Ring bis zu zwei aromatische oder cycloaliphatische Ringe ankondensiert sein können.

Wenn $R^1$, $R^2$, $R^3$, $R^4$, $R^5$, $R^6$ oder $R^7$ Alkylgruppen bedeuten, haben diese im allgemeinen 1 bis 4, bevorzugt 1 bis 2 Kohlenstoffatome. Substituenten, die an die aromatischen oder cycloaliphatischen Ringe gebunden sein können, sind z.B. Alkylgruppen, Alkoxygruppen, Halogenatome, Nitrogruppen oder Carboxylgruppen.

Beispiele für geeignete Säureanhydride sind:

Maleinsäureanhydrid und Derivate,

z.B. Dimethylmaleinsäureanhydrid, Citraconsäureanhydrid, Chlormaleinsäureanhydrid oder Dichlormaleinsäureanhydrid,

Bernsteinsäureanhydrid und Derivate,

z.B. Methylbernsteinsäureanhydrid, Glutarsäureanhydrid und Derivate, z.B. 3-Methylglutarsäureanhydrid, 3,3-Tetramethylen-glutarsäureanhydrid oder Camphersäureanhydrid,

3-Oxa-glutarsäureanhydrid und Derivate,

Phthalsäureanhydrid und Substitutionsprodukte,

z.B. Chlor-, Nitro- oder Carboxyphthalsäureanhydrid,

teilweise oder vollständig hydrierte Phthalsäureanhydride, z.B. Hexahydrophthalsäureanhydrid oder Cyclohexen-1,2-dicarbonsäureanhydrid,
Naphthalin-2,3-dicarbonsäureanhydrid oder Naphthalin-1,8-dicarbonsäureanhydrid und deren Substitutionsprodukte,
Pyridin-o-dicarbonsäureanhydrid und dessen Substitutionsprodukte,
Pyrazin-o-dicarbonsäureanhydrid und dessen Substitutionsprodukte,
Furan-o-dicarbonsäureanhydrid oder Furan-2,5-dicarbonsäureanhydrid, deren Substitutionsprodukte sowie deren teilweise oder vollständig hydrierte Derivate,
Thiophen-o-dicarbonsäureanhydrid oder Thiophen-2,5-dicarbonsäureanhydrid, deren Substitutionsprodukte sowie deren ganz oder teilweise hydrierte Derivate,
di- oder polycyclische Anhydride, die durch Diels-Alder-Reaktion eines Diens mit Maleinsäureanhydrid entstehen, z.B. die Additionsprodukte aus Furan, Anthracen, Cyclohexadien-1,3 oder Cyclopentadien und Maleinsäureanhydrid.

Bevorzugt werden die Reaktionsprodukte mit Malein-, Phthal-, Bernstein-, 3-Oxa-glutarsäure- und Pyridin-2,3-dicarbonsäureanhydrid.

Als Hydroxygruppen enthaltende Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester-oder Vinylacetal- oder Vinylalkoholeinheiten geeignet.

Das Molekulargewicht der Carboxylgruppen enthaltenden Bindemittel kann innerhalb weiter Bereiche variieren. Im allgemeinen werden Bindemittel mit mittleren Molekulargewichten zwischen 5.000 und etwa 200.000 und darüber, vorzugsweise zwischen 10.000 und 100.000 eingesetzt. Die Säurezahl der Bindemittel kann im allgemeinen zwischen 5 und 80, bevorzugt zwischen 10 und 70 liegen.

Der Mengenanteil an Bindemittel in der Zwischenschicht beträgt im allgemeinen 15 bis 95, vorzugsweise 30 bis 90 Gew.-%, bezogen auf die nichtflüchtigen Bestandteile der lichtempfindlichen Zwischenschicht.

In der lichtempfindlichen Schicht liegt der Anteil der erfindungsgemäß eingesetzten Bindemittel im allgemeinen zwischen 5 bis 80, bevorzugt zwischen 10 bis 60 Gew.-%, bezogen auf die nichtflüchtigen Bestandteile dieser Schicht.

Für die lichtempfindliche Schicht lassen sich prinzipiell die gleichen polymeren Bindemittel verwenden, wobei insbesondere die in der DE-OS 34 04 366 beschriebenen Polymere bevorzugt sind. Mit ähnlich gutem Erfolg lassen sich jedoch auch die Bindemittel, welche aus den gleichzeitig eingereichten Anmeldungen (86/K068, 86/K069 und 86/K070) bekannt sind, verwenden.

Die Bindemittel der lichtempfindlichen Schicht können mit denen der Zwischenschicht gleich oder verschieden sein. Es hat sich allerdings als vorteilhaft erwiesen, wenn die verwendeten Bindemittel strukturell ähnlich sind.

Die lichtempfindliche Schicht enthält darüber hinaus eine photopolymerisierbare Verbindung sowie einen geeigneten Photoinitiator.

Als Photoinitiatoren können eine Vielzahl von Verbindungen, gegebenenfalls auch Gemische von zwei oder mehreren verschiedenen, oftmals synergistisch wirkenden Verbindungen Verwendung finden. Beispiele sind Benzoin und seine Derivate, Mehrkernchinone, Acridinderivate, z. B. 9-Phenylacridin, 9-(p-Methoxyphenyl)-acridin, Benz[a]phenazin, 10-Methoxy-benz[a]phenazin; Chinoxalinderivate, z. B. 6,4′,4″-Trimethoxy-2,3-diphenyl-chinoxalin, 4′,4″-Dimethoxy-2,3-diphenyl-5-azachinoxalin; aromatisch substituierte Bis-trichlormethyl-s-triazine oder trichlormethylsubstituierte Carbonylmethylenheterocyclen, z. B. 2-(p-Trichlormethyl-benzoylmethylen)-3-ethyl-benzthiazolin. Derartige Trichlormethylverbindungen werden besonders bevorzugt. Die Menge der Photoinitiatoren liegt im allgemeinen zwischen 0,05 und 10, bevorzugt zwischen 0,5 und 5 Gew.-%. dieser Schicht, bezogen auf die nichtflüchtigen Bestandteile.

Als photopolymerisierbare Verbindungen werden bevorzugt Acryl- oder Methacrylsäureester, sowie Acryl- oder Methacrylsäureurethane von mehrwertigen, insbesondere primären Alkoholen eingesetzt.

Die Alkohole können 1 - 8, bevorzugt 2 bis 6 OH-Gruppen enthalten.

Beispiele für geeignete Ester sind Trimethylolpropantriacrylat und -methacrylat, sowie seine ethoxylierten oder propoxylierten Derivate, Pentaerythrittri- und -tetraacrylat oder die entsprechenden Methacrylate, Dipentaerythritmonohydroxypentaacrylat und -methacrylat, Dipentaerythrithexaacrylat und -methacrylat, Propylenglykoldiacrylat und -methacrylat, Glycerin-di-und -tri-(meth)acrylat, Polyethylenglykoldi(meth)acrylat und Bis(meth)acrylate von oxyethylierten Bisphenol-A-Derivaten. Derartige Verbindungen sind formal durch Umsetzung von Alkoholen mit den entsprechenden (Meth)acrylsäurederivaten herzustellen. Werden die Alkohole mit Isocyanatoalkyl(meth)acrylaten umgesetzt, so erhält man strukturell ähnliche Urethangruppen

im Monomeren bzw. Oligomeren, die mit gleichem Vorteil Verwendung finden können.

Geeignete Urethangruppen enthaltende Monomere oder Oligomere lassen sich jedoch auch derart herstellen, daß man beispielsweise ein Hydroxyalkyl(meth)acrylat mit einem zwei oder mehrwertigen Isocyanat umsetzt. Diese Isocyanate können wiederum durch Umsetzung von Diisocyanaten mit Diolen oder Triolen zu oligomeren Verbindungen erhalten worden sein. Schließlich lassen sich geeignete Urethangruppen enthaltende Monomere oder Oligomere auch derart erhalten, daß man ein Diisocyanat mit einem Polyol derart umsetzt, daß das Produkt noch freie OH-Gruppen aufweist, welche schließlich mit einem (Meth)-acrylsäurederivat oder einem ungesättigten Isocyanat abreagieren.

Geeignete Monomere lassen sich auch dadurch herstellen, daß ein niedermolekulares oder oligomeres Epoxid mit einem (Meth)acrylsäurederivat umgesetzt wird. Die dabei entstehenden freien OH-Gruppen können ebenfalls, je nach Bedarf, ganz oder teilweise mit einer ungesättigten Verbindung verestert vorliegen.

Die im Rahmen der Erfindung bevorzugt eingesetzten photopolymerisierbaren Verbindungen haben einen Siedepunkt bei Normaldruck oberhalb von 100 °C und besitzen Molekulargewichte zwischen 300 und 5000 g/mol. Der Anteil an photopolymerisierbaren Verbindungen, bezogen auf die nichtflüchtigen Bestandteile der lichtempfindlichen Schicht, beträgt 10 bis 65, bevorzugt 30 bis 60 Gew.-%.

Beiden Schichten können darüber hinaus Säuren, Inhibitoren für die thermische Polymerisation oder thermisch aktivierbare Initiatoren, Farbstoffe, Pigmente, Verlaufmittel, Weichmacher, Netzmittel und andere übliche Zusätze enthalten.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen entscheidenden Anteil des für die Vernetzung notwendigen Lichts absorbieren dürfen.

Zur Stabilisierung sowohl der lichtempfindlichen Schicht als auch der lichtempfindlichen Zwischenschicht ist es vorteilhaft, diesen eine Verbindung mit Säurecharakter zuzusetzen. In Betracht kommen Mineralsäuren und starke organische Säuren, wie beispielsweise Phosphorsäure, Schwefelsäure, Perchlorsäure, Borsäure oder p-Toluolsulfonsäure. Besonders geeignet ist für diesen Zweck die Phosphorsäure.

Beide Schichten können Farbstoffe und/oder Farbpigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Viktoriareinblau FGA (C.I. Basic Blue 81), Renolblau B2G-HW (C.I. 74160), Kristallviolett (C.I. 42555), Rhodamin 6 GDN (C.I. 45160) oder Renolkarmin-FBB-HW (C.I. Pigment Red 146). Zur Erhöhung des Bildkontrastes bei der Belichtung können Metanilgelb (C.I. 13065), Methylorange (C.I. 13025) oder bevorzugt Phenylazodiphenylamin verwendet werden.

Für gewisse Anwendungen hat es sich als sinnvoll erwiesen, einer der beiden Schichten ein Pigment hinzuzufügen, dessen mittlere Teilchengröße größer ist als die Gesamtschichtdicke der lichtempfindlichen Schichten. Derartige Pigmente verkürzen die Evakuierungszeit im Belichtungsrahmen erheblich und erniedrigen die Gefahr von Lufteinschlüssen zwischen Aufzeichnungsmaterial und Vorlage, was beispielsweise zu unerwünschten Unterstrahlungen führen kann.

Schließlich können entweder beiden oder aber einer der lichtempfindlichen Schichten thermische Initiatoren für eine durch Wärme initiierte Nachpolymerisation bzw. -vernetzung einverleibt werden. Derartige thermische Initiatoren werden in der Anmeldung P 36 17 499.8 (86/K025) beschrieben.

Für die Zwischenschicht läßt sich somit folgende bevorzugte Zusammensetzung an nichtflüchtigen Bestandteilen festhalten:

| | |
|---|---|
| Bindemittel: | 30 bis 90 % |
| Diazoniumsalz-Polykondensationsprodukt: | 10 bis 70 % |
| Säure: | 0 bis 10 % |
| Farbstoff oder Farbpigment: | 0 bis 10 % |
| Belichtungskontrastgeber: | 0 bis 5 % |
| Abstandspigment: | 0 bis 55 % |
| Thermischer Initiator: | 0 bis 5 % |

Für die lichtempfindliche Schicht läßt sich die bevorzugte Zusammensetzung folgendermaßen zusammenfassen:

| | |
|---|---|
| Bindemittel: | 10 bis 50 % |
| Diazoniumsalz-Polykondensationsprodukt: | 10 bis 40 % |
| Photopolymerisierbare Verbindung: | 30 bis 60 % |
| Photoinitiator: | 0,5 bis 5 % |
| Säure: | 0 bis 10 % |
| Farbstoff oder Farbpigment: | 0 bis 10 % |
| Belichtungskontrastgeber: | 0 bis 5 % |
| Abstandspigment: | 0 bis 5 % |
| Thermischer Initiator: | 0 bis 5 % |

Die Beschichtung eines geeigneten Trägermaterials mit den beiden lichtempfindlichen Schichten erfolgt aus entsprechenden organischen Lösungsmitteln oder Lösungsmittelgemischen, im allgemeinen durch Gießen oder Sprühen. Zu diesem Zweck wird zunächst die Zwischenschicht aufgetragen, ausreichend getrocknet und anschließend die lichtempfindliche Schicht auf diese aufgetragen. Die Trocknung dieser Schicht sollte dabei so rasch erfolgen, daß die Oberfläche der Zwischenschicht nur geringfügig angelöst werden kann. Die lichtempfindlichen Schichten können aber auch zunächst auf einen temporären Schichtträger aufgebracht werden, von dem sie mechanisch abtrennbar sind, und deswegen durch Laminieren auf den endgültigen Schichtträger, z. B. eine Nickelfolie oder die Kupferschicht einer Leiterplatte übertragen werden.

Als Lösungsmittel zur Bereitung der Beschichtungslösungen können je nach den Schichtbestandteilen z. B. Alkohole, wie Methanol oder Ethanol, Glykolether, wie Ethylenglykolmonomethylether oder Propylenglykolmonomethylether, Dimethylformamid oder Diethylformamid, Ether, wie Dioxan oder Tetrahydrofuran, Ester, wie Essigsäureethylester, Butylacetat oder Ethylenglykolmonomethyletheracetat, Ketone wie Ethylmethylketon oder Cyclohexanon, oder dergleichen, verwendet werden. Als günstige Lösungsmittel haben sich dabei die Partialether der Glykole erwiesen, z. B. Ethylenglykolmonomethylether.

Die Schichtdicke der Zwischenschicht beträgt 0,1 bis 3,0 µm, vorzugsweise 0,2 bis 1,2 µm, die der Schicht 0,25 bis 6,0 µm, vorzugsweise 0,4 bis 2,0 µm. Die Gesamtschichtdicke beider Schichten liegt zwischen 0,5 bis 6 µm, vorzugsweise zwischen 1,0 und 3,0 µm. Das Schichtdickenverhältnis Zwischenschicht zu Schicht kann im Bereich zwischen 1:50 bis 5:1 variieren, bevorzugt ist jedoch ein Verhältnis von 1:10 bis 2:1.

Als Schichtträger eignen sich z. B. Magnesium, Zink, Kupfer, mechanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Die Gemische können auch in der Photoresisttechnik eingesetzt werden, z. B. zur Herstellung von Hoch-, Tief-oder Mehrmetalldruckplatten oder von gedruckten Schaltungen. Bei dieser Anwendung ist in vielen Fällen die erhöhte Auflösung gegenüber den sonst verwendeten photopolymerisierbaren Gemischen von besonderem Vorteil.

Besonders bevorzugt wird das Gemisch zur Herstellung von Flachdruckformen verwendet, wobei als Trägermaterial Aluminium bevorzugt wird.

Für diesen Zweck eignet sich bevorzugt Aluminium, das in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Polyvinylphosphonsäure, Alkalisilikat, Phosphat, Hexafluorozirkonat, Chromat, Borat, Polyacrylamid und Cellulosederivaten, ist vorteilhaft.

Die Verarbeitung der aus den Gemischen erhaltenen Kopiermaterialien erfolgt in bekannter Weise durch bildmäßiges Belichten und Auswaschen der unbelichteten Schichtbereiche mit einem geeigneten Entwickler.

Die Belichtung des Kopiermaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 µm emittieren, oder YAG-Laser, die bei 1,06 µm emittieren.

Als Entwicklerlösungen werden wäßrig-alkalische Lösungen mit einem pH-Wert im Bereich von 8 bis

14, vorzugsweise 9 bis 12, verwendet, die Puffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Polymere verwendet. Die Lösung kann auch geringe Mengen, z. B. bis zu 5, bevorzugt nicht mehr als 2 Gew.-% an mit Wasser mischbaren organischen Lösungsmitteln enthalten. Bevorzugt werden schwerflüchtige Lösungsmittel, z. B. araliphatische Alkohole, deren Dampfdruck bei der Handhabung des Entwicklers nicht ins Gewicht fällt.

Die Entwicklung kann in bekannter Weise durch Tauchen, Besprühen, Bürsten oder Tamponieren erfolgen.

Die entwickelte Druckplatte kann noch zusätzlich durch Erwärmen auf eine Temperatur im Bereich von 150 - 230 °C nachgehärtet werden. Im allgemeinen reicht eine Zeit von 2 bis 20 Minuten für die Nachhärtung aus. Diese kann durch den vorstehend beschriebenen Zusatz von thermisch aktivierbaren Initiatoren noch verkürzt werden. In diesem Fall läßt sich die thermische Nachhärtung auch bei niedrigeren Temperaturen durchführen. Ein weiterer Vorteil ist die Möglichkeit, durch Belichten bzw. Bestrahlen die entwickelte Druckform nachzuhärten. Diese Form der Nachbehandlung ist bei einer Druckplatte, die das erfindungsgemäße Zweischichtensystem aufweist, wesentlich wirkungsvoller als bei einer Platte, die beispielsweise nur eine Diazoniumsalz-Kondensat- oder Photopolymer-Monoschicht aufweist.

Das erfindungsgemäße Zweischichtensystem weist gegenüber den bekannten Monoschichten, die aus Diazoniumsalz-Polykondensationsprodukten und/oder Photopolymersystemen bestehen, sehr wesentliche Vorteile auf:

Gegenüber Monoschichten, die lediglich ein Diazoniumsalz-Polykondensationsprodukt und ein Bindemittel enthalten, zeigen die erfindungsgemäßen lichtempfindlichen Aufzeichnungsmaterialien eine höhere Lichtempfindlichkeit, insbesondere auch bei höheren Schichtdicken, eine schnellere Entwickelbarkeit mit wäßrig-alkalischen Entwicklern und deren höhere Ergiebigkeit, eine günstigere Tonwertwiedergabe und eine geringere Unterstrahlungsanfälligkeit. Ganz besonders hervorzuheben ist allerdings eine deutlich gesteigerte Druckauflage sowie eine verminderte Anfälligkeit gegenüber Farben, die einen höheren Anteil an Lösungsmitteln aufweisen, wie es beispielsweise bei den UV-härtbaren Farben der Fall ist. Darüber hinaus ist die Farbannahme der erfindungsgemäßen Aufzeichnungsmaterialien verbessert.

Gegenüber Monoschichten, die lediglich ein Photopolymersystem und ein Bindemittel enthalten, ist als Vorteil zu nennen, daß die erfindungsgemäßen Doppelschichten keine Sauerstoffsperrschicht benötigen. Wesentlich besser ist die Auflösung der erfindungsgemäßen Doppelschicht sowie die Tonwertwiedergabe und die verringerte Unterstrahlungsneigung, was von keinem bekannten System erreicht wird.

Gegenüber Monoschichten, die eine Kombination aus Diazoniumsalz-Polykondensationsprodukten und Photopolymeren enthalten, weisen die erfindungsgemäßen Schichten wiederum eine deutlich verbesserte Lichtempfindlichkeit, bessere Tonwertwiedergabe und verringerte Unterstrahlungsneigung auf. Wesentlicher Vorteil ist jedoch die deutlich erhöhte Lagerstabilität, insbesondere bei erhöhten Temperaturen oder unter der Einwirkung hoher Luftfeuchtigkeit.

Das erfindungsgemäße Aufzeichnungsmaterial bietet daher in vielerlei Hinsicht Vorteile gegenüber den bisher bekannten Aufzeichnungsmaterialien, mit denen der Anwender eine erhebliche Kostenersparnis, eine Verringerung des Zeitaufwands sowie erhebliche Qualitätsverbesserungen erzielen wird.

Die folgenden Beispiele sollen die Erfindung erläutern. Gewichtsteile und Volumteile stehen im Verhältnis von g zu $cm^3$; Prozentangaben und Mengenverhältnisse sind in Gewichtseinheiten zu verstehen, sofern nichts anderes angegeben ist.

<u>Beispiel 1</u>

Ein in Salpetersäure elektrochemisch aufgerauhtes und anodisiertes Aluminiumblech wurde zur Verbesserung der Hydrophilie mit einer 0,1 %-igen wäßrigen Lösung von Polyvinylphosphonsäure behandelt. Auf das in dieser Weise behandelte Aluminiumblech wurde die folgende Mischung in einer solchen Menge aufgetragen, daß nach deren Trocknung ein Trockenschichtgewicht von 0,6 $g/m^2$ resultierte:

| | |
|---|---|
| 62 Gt | des Umsetzungsprodukts eines Polyvinylbutyrals, das 71 Gew.-% Vinylbutyral-, 2 Gew.-% Vinylacetat- und 27 Gew.-% Vinylalkoholeinheiten enthält und ein Molekulargewicht von 70.000 bis 80.000 aufweist, mit Maleinsäureanhydrid (Säurezahl des Umsetzungsproduktes: 30), |
| 21 Gt | eines Diazoniumsalz-Polykondensationsprodukts, hergestellt aus 3-Methoxydiphenylamin-4-diazoniumsulfat und 4,4′-Bis-methoxymethyldiphenylether (Molverhältnis 1:1) in 85%iger Phosphorsäure und isoliert als Mesitylensulfonat, |
| 2,5 Gt | 85%-ige Phosphorsäure, |
| 3 Gt | Viktoriareinblau FGA (C.I. Basic Blue 81) und |

0,7 Gt Phenylazodiphenylamin in einer Mischung aus
2570 Gt Ethylenglykolmonomethylether und
780 Gt Tetrahydrofuran.

Nach Trocknung dieser Mischung wurde auf das derart vorbeschichtete Aluminiumblech eine Mischung nachstehender Zusammensetzung derart aufgetragen, daß nach deren Trocknung ein Gesamttrockenschichtgewicht von 1,9 g/$m^2$ resultierte:

60 Gt des vorstehend beschriebenen Umsetzungsprodukts aus einem Polyvinylbutyral mit Maleinsäureanhydrid,
18 Gt des beschriebenen Diazoniumsalz-Polykondensationsprodukts,
3,6 Gt Viktoriareinblau FGA (C.I. Basic Blue 81),
60 Gt eines technischen Gemisches aus Pentaerythrittri- und -tetraacrylat,
4,8 Gt 2-(4-Styrylphenyl)-4,6-bis-trichlormethyl-s-triazin und
1,6 Gt 85 %-ige Phosphorsäure in einer Mischung aus
2900 Gt Ethylenglykolmonomethylether und
3050 Gt Ethylmethylketon.

Die zweilagige Kopierschicht wurde unter einer Negativvorlage belichtet und mit der nachstehend beschriebenen Entwicklerlösung entwickelt:

0,2 Gt Natriummetasilikat × 9 Wasser,
3,9 Gt Dinatriumhydrogenphosphat × 12 Wasser,
3,5 Gt Trinatriumphosphat × 12 Wasser,
1,5 Gt Kaliumtetraborat × 4 Wasser und
2,9 Gt Natriumoctylsulfat in
88 Gt entsalztem Wasser

Die innerhalb kurzer Zeit entwickelte Druckform wurde in einer Offsetdruckmaschine eingespannt und erzielte 420.000 einwandfreie Drucke. Die Druckform wies keine erkennbaren Beschädigungen auf.

Beispiel 2

Auf das in Beispiel 1 beschriebene Trägermaterial wurde eine lichtempfindliche Schicht folgender Zusammensetzung aufgetragen:

15,7 Gt des Umsetzungsprodukts des in Beispiel 1 beschriebenen Polyvinylbutyrals mit 3-Oxaglutarsäureanhydrid (Säurezahl des Umsetzungsprodukts: 50),
15,7 Gt des in Beispiel 1 beschriebenen Diazoniumsalz-Polykondensationsprodukts,
1,0 Gt 85 %ige Phosphorsäure,
1,2 Gt Renolblau B2G-HW (C.I. 74 160) und
0,2 Gt Phenylazodiphenylamin in
1200 Gt Ethylenglykolmonomethylether.

Das Schichtgewicht der lichtempfindlichen Vorbeschichtung betrug nach dem Trocknen 1,0 g/$m^2$. Auf diese Vorbeschichtung wurde eine zweite lichtempfindliche Schicht mit nachstehender Zusammensetzung aufgetragen:

15,0 Gt des in Beispiel 1 beschriebenen Umsetzungsproduktes eines Polyvinylbutyrals mit Maleinsäureanhydrid,
8,8 Gt des in Beispiel 1 beschriebenen Diazoniumsalz-Polykondensationsprodukts,
0,9 Gt Viktoriareinblau FGA (C.I. Basic Blue 81),
16,8 Gt des in Beispiel 1 beschriebenen technischen Gemisches von Pentaerythritestern,
1,6 Gt des in Beispiel 1 beschriebenen Triazins und
0,4 Gt 85 %ige Phosphorsäure in einer Mischung aus
740 Gt Ethylenglykolmonomethylether und
216 Gt Ethylmethylketon.

Das Trockenschichtgewicht der oberen Schicht betrug 0,7 g/$m^2$, so daß ein Gesamttrockengewicht von 1,7 g/$m^2$ resultierte.

Die zweilagige Kopierschicht wurde unter einer Negativvorlage mit einer Metallhalogenid-Lampe von 5 kW Leistung 28 Sekunden belichtet.

Die belichtete Schicht wurde mit dem Entwickler aus Beispiel 1 entwickelt. Dazu wurde das Aluminiumblech 30 Sekunden in eine Küvette mit dem Entwickler getaucht, mit einer Wasserbrause abgespült und anschließend mit einem weichen Tampon nachgerieben. Die nichtbelichteten Schichtbereiche ließen sich vollständig entfernen; auch feinste Strukturelemente der Vorlage waren einwandfrei wiedergegeben.

In der Kopie war die Stufe 5 eines Silberfilm-Halbtonstufenkeils mit einem Dichtewertumfang von 0,15

bis 1,5 und Dichteinkrementen von 0,15 noch vollständig gedeckt.

Mit der Druckform wurden in einer Bogenoffsetmaschine 250.000 Drucke angefertigt. Die Überprüfung der Druckform nach der Herausnahme zeigte, daß diese auch in den feinsten Strukturelementen und Rasterpartien keinerlei Beschädigungen aufwies.

Beispiel 3

Ein mit Salzsäure elektrochemisch aufgerauhtes, anodisiertes und mit einer 0,1 %igen wäßrigen Lösung von Polyvinylphosphonsäure nachbehandeltes Aluminiumblech, das ein Oxidgewicht von 4 g/m$^2$ aufwies, wurde, wie in den vorhergehenden Beispielen beschrieben, nacheinander mit folgenden lichtempfindlichen Mischungen beschichtet. Zuerst:

| | |
|---|---|
| 35,1 Gt | des Umsetzungsprodukts des in Beispiel 1 beschriebenen Polyvinylbutyrals mit Phthalsäureanhydrid (Säurezahl des Umsetzungsprodukts 45), |
| 23,4 Gt | eines Diazoniumsalz-Kondensationsprodukts, hergestellt durch Kondensieren von 3-Methoxydiphenylamin-4-diazoniumsulfat mit 4-Methyl-4′-methoxymethyldiphenylether und anschließend mit 4,4′-Bismethoxymethyldiphenylether (Molverhältnis 1:1:1) in 85 %iger Phosphorsäure und isoliert als Mesitylensulfonat, |
| 2,1 Gt | 85 %ige Phosphorsäure, |
| 1,5 Gt | Viktoriareinblau FGA (C.I. Basic Blue 81) und |
| 1,1 Gt | Phenylazodiphenylamin in |
| 1900 Gt | Ethylenglykolmonomethylether |

und schließlich:

| | |
|---|---|
| 30 Gt | des vorstehend beschriebenen Umsetzungsprodukts Polyvinylbutyral aus Beispiel 1 mit Phthalsäureanhydrid (Säurezahl: 45), |
| 8,8 Gt | des in Beispiel 1 beschriebenen Diazoniumsalz-Polykondensationsprodukts, |
| 1,8 Gt | Viktoriareinblau FGA (C.I. Basic Blue 81),, |
| 30 Gt | Dipentaerythrithexaacrylat, |
| 2,4 Gt | 2-(4-Methoxynaphthyl)-4,6-bis-trichlor-methyltriazin und |
| 0,8 Gt | 85 %ige Phosphorsäure in einer Mischung aus |
| 954 Gt | Ethylenglykolmonomethylether und |
| 862 Gt | Tetrahydrofuran. |

Das Gesamttrockenschichtgewicht dieser zwei lichtempfindlichen Schichten betrug 2,2 g/m$^2$, wobei auf die untere Schicht 1,0 g/m$^2$ entfielen.

Das Gemisch wurde, wie in den vorgehenden Beispielen beschrieben, belichtet und mit einer Entwicklerlösung folgender Zusammensetzung entwickelt:

| | |
|---|---|
| 0,1 Gt | Natriummetasilikat x 9 Wasser, |
| 3,9 Gt | Dinatriumhydrogenphosphat x 12 Wasser, |
| 3,4 Gt | Trinatriumphosphat x 12 Wasser, |
| 1,5 Gt | Kaliumtetraborat x 4 Wasser, |
| 2,0 Gt | Kaliumoxalat x Wasser, |
| 2,5 Gt | Natriumbenzoat und |
| 2,0 Gt | Phenoxyethanol in |
| 84,6 Gt | entsalztem Wasser. |

Durch Überwischen mit einem mit dieser Lösung getränkten Plüschtampon wurden bereits innerhalb weniger Sekunden die nichtbelichteten Schichtbereiche vollständig entfernt.

Eingespannt in eine Bogenoffsetmaschine nahmen die Bildbereiche ungewöhnlich rasch die angebotene fette Farbe an. Die erzielte Auflage lag deutlich oberhalb von 400.000 Drucken.

Beispiel 4

Das gemäß Beispiel 1 vorbehandelte Aluminiumblech wurde nacheinander mit den nachstehend beschriebenen Mischungen beschichtet. Zuerst:

| | |
|---|---|
| 1,5 Gt | des in Beispiel 1 angegebenen Umsetzungsprodukts aus einem Polyvinylbutyral mit Maleinsäureanhydrid, |
| 0,7 Gt | eines Diazoniumsalz-Polykondensationsprodukts aus 3-Methoxy-diphenylamin-4-diazoniumsulfat mit Formaldehyd, |
| 0,1 Gt | Viktoriareinblau FGA (C.I. Basic Blue 81), |
| 0,1 Gt | 85 %ige Phosphorsäure und |

0,2 Gt Phenylazodiphenylamin in
80 Gt Ethylenglykolmonomethylether

und schließlich:

1,5 Gt des in Beispiel 1 angegebenen Umsetzungsprodukts aus einem Polyvinylbutyral mit Maleinsäureanhydrid,
0,6 Gt des vorstehend beschriebenen Diazoniumsalz-Polykondensationsprodukts,
1,8 Gt eines technischen Gemischs aus Pentaerythrittri- und -tetraacrylat,
0,2 Gt des in Beispiel 1 beschriebenen Triazins und
0,03 Gt 85 %ige Phosphorsäure in einer Mischung aus
72 Gt Ethylenglykolmonomethylether und
20,2 Gt Ethylmethylketon.

Das Trockenschichtgewicht betrug je Schicht 1 g/m$^2$.

Die Verarbeitung erfolgte wie in Beispeil 1 angegeben. Die Druckauflage in einer Rollenoffsetdruckmaschine lag bei 280.000.

## Beispiel 5 und Vergleichsbeispiel 6

Ein in Salpetersäure elektrochemisch aufgerauhtes, anodisiertes und mit einer 0,1 %igen wäßrigen Lösung von Polyvinylphosphonsäure nachbehandeltes Aluminiumblech wurde mit den in Beispiel 1 beschriebenen Mischungen beschichtet. Das Trockenschichtgewicht der unteren Schicht betrug 1 g/m$^2$, das der oberen Schicht 1,2 g/m$^2$, so daß ein Gesamttrockenschichtgewicht von 2,2 g/m$^2$ resultierte. Zum Vergleich wurde auf ein in gleicher Weise behandeltes Aluminiumblech lediglich zu einem Trockenschichtgewicht von 2,2 g/m$^2$ eine Schicht aufgetragen, die in ihrer Zusammensetzung der unteren Schicht entsprach.

Beide gleich dick beschichteten Bleche wurden 30 Sekunden lang durch eine handelsübliche Negativvorlage mit einer Metallhalogenid-Lampe von 5 kW Leistung bestrahlt.

Zur Entwicklung wurde das Entwicklergemisch aus Beispiel 3 verwendet, wobei die Einwirkung durch leichtes Reiben mit einem Plüschtampon verbessert wurde.

Die zweischichtige Druckform ließ sich innerhalb weniger Sekunden schleierfrei aufentwickeln. Die Vorlage war auch in den feinen Strich- und Rasterelementen differenziert wiedergegeben.

Demgegenüber ließ sich die einschichtige, ebenso dicke Druckform des Vergleichsbeispiels nur sehr langsam und nicht praxisgerecht aufentwickeln. Auch nach längerem Reiben mit dem Plüschtampon waren die nichtbelichteten Bildbereiche, insbesondere in den feinen Wiedergabeelementen, nur schlecht entfernbar.

Die Erprobung der Druckformen in einer Druckmaschine zeigte sich darüber hinaus, daß die Vergleichsplatte undifferenziert druckt, wobei feine Nichtbildstrichelemente bis zu einer Dicke von etwa 30$\mu$m praktisch nicht wiedergegeben wurden.

Die zweischichtige Druckform wies diese Unzulänglichkeiten nicht auf. Auch in der Aufgabenleistung war diese Druckform dem Vergleichsbeispiel um ca. 35 % überlegen.

## Beispiele 7 bis 12 und Vergleichsbeispiele 13 und 14

Mit den folgenden Beispielen soll gezeigt werden, daß eine Variation der Schichtdickenverhältnisse der beiden lichtempfindlichen Schichten innerhalb eines Bereichs von 1 : 20 bis 1,5 : 1 (Zwischenschicht: Schicht) unter Beibehaltung der beschriebenen Entwicklungs- und Druckvorteile möglich ist.

Zu diesem Zweck wurden zwei Beschichtungslösungen folgender Zusammensetzung hergestellt und in unterschiedlicher Menge auf ein wie in Beispiel 1 aufgerauhtes, anodisiertes und hydrophilisiertes Aluminiumblech aufgetragen, so daß verschiedene Zwischenschicht- bzw. Schichtdicken, aber eine einheitliche Gesamttrockenschichtdicke resultierte.

Zuerst:

258 Gt einer 6,8 %igen Lösung des Umsetzungsprodukts aus einem Polyvinylbutyral mit einem Molekulargewicht von etwa 30.000 sowie einer OH-Zahl von 220 mit Maleinsäureanhydrid (Säurezahl des Umsetzungsprodukts: 35), in Ethylmethylketon,
16,7 Gt des in Beispiel 1 beschriebenen Diazoniumsalz-Polykondensationsprodukts,
1,2 Gt 85 %ige Phosphorsäure,
1,4 Gt Renolblau B2G-HW (C.I. 74160) und
0,5 Gt Phenylazodiphenylamin in
600 Gt Ethylenglykolmonomethylether

und schließlich:

| | |
|---|---|
| 220 Gt | des vorstehend beschriebenen Umsetzungsprodukts aus einem Polyvinylbutyral mit Maleinsäureanhydrid, |
| 4,5 Gt | des in Beispiel 1 beschriebenen Diazoniumsalz-Polykondensationsprodukts, |
| 1,0 Gt | Renolblau B2G-HW (C.I. 74160), |
| 15,0 Gt | des in Beispiel 1 beschriebenen technischen Gemisches aus Pentaerythritestern, |
| 1,2 Gt | des in Beispiel 1 beschriebenen Triazins und |
| 0,4 Gt | 85 %ige Phosphorsäure in |
| 680 Gt | Ethylenglykolmonomethylether. |

Nachdem die untere Beschichtung auf dem Blech getrocknet war, wurde die Lösung der zweiten Schicht auf diese aufgetragen. Die fertig beschichteten Bleche wurden einige Tage unter Lichtausschluß bei Raumtemperatur gelagert. Anschließend wurde 30 sec mit der in Beispiel 1 beschriebenen Lichtquelle durch eine handelsübliche Negativvorlage belichtet. Die belichteten Platten wurden mit dem in Beispiel 3 beschriebenen Entwicklergemisch und in der dort beschriebenen Weise verarbeitet.

Vor dem Einspannen der Platten in eine Bogenoffsetmaschine wurden diese mit einem handelsüblichen Gummierungspräparat konserviert. Für das Vergleichsbeispiel 13 (≙ DE-A 34 04 366) wurde lediglich die Zusammensetzung entsprechend der Zwischenschicht, für das Vergleichsbeispiel 14 (≙ P 35 28 309.2) nur die entsprechend der Schicht, allerdings mit jeweils auch mit den Beispielen identischen Trockenschichtdicken aufgetragen.

Auch die Verarbeitung der Platten der Vergleichsbeispiele wurde wie vorstehend beschrieben durchgeführt.

Nachstehende, tabellarisch zusammengefaßte Ergebnisse wurden erhalten:
Die Tabelle zeigt, daß das zweischichtige System gegenüber den Monoschichten Vorteile bezüglich Lichtempfindlichkeit und Entwickelbarkeit aufweist sowie günstigere kopier- und drucktechnische Eigenschaften zeigt.

| Beispiele/Vergleichsbeispiele | 7 | 8 | 9 | 10 | 11 | 12 | 13 | 14 |
|---|---|---|---|---|---|---|---|---|
| Trockenschichtdicke ($g/m^2$) der | | | | | | | | |
| Zwischenschicht | 0,2 | 0,4 | 0,6 | 0,8 | 1,0 | 1,2 | 1,8 | 0,0 |
| Schicht | 1,6 | 1,4 | 1,2 | 1,0 | 0,8 | 0,6 | 0,0 | 1,8 |
| Gesamtschicht | 1,8 | 1,8 | 1,8 | 1,8 | 1,8 | 1,8 | 1,8 | 1,8 |
| Belichtungszeit (s) | 30 | 30 | 30 | 30 | 30 | 30 | 30 | 30 |
| Entwicklungszeit [a] | 12 | 12 | 12 | 12 | 12 | 12 | 25 | 15 |
| Wiedergabe [b] (µm) | 6-8 | 6-8 | 6-8 | 6-8 | 6-8 | 6-8 | 10 | 8-10 |
| Volltonstufe [c] (Platte) | 4-(5) | 4-(5) | 4 | 4 | 4 | 4 | 3 | 3 |
| Freie Stufe [c] (Platte) | 7 | 7 | 6 | 6 | 6 | 6 | 8 | 7 |
| Vollton [d] (Druck) | 4 | 4 | 4 | 4 | 4 | 4 | 4 | 4 |
| Freie Stufe [d] (Druck) | 6 | 6 | 6 | (5)-6 | (5)-6 | (5)-6 | 8 | 6-(7) |
| Wiedergabe [b] (Druck) | 8-(10) | 8-(10) | 8 | 8 | 8 | 8 | 12-15 | 12 |
| Auflage (in Tausend) | 400 + | 380 | 400 + | 400 + | 400 + | 400 + | 305 | 400[e] |

Erläuterungen:

a: Zeit bis zur vollständigen Ablösung der Schicht in den Nichtbildbereichen

b: Wiedergabe der Linienbreite in den Nichtbildbereichen. Die Wiedergabe der Linienbreite in Bildbereichen war in allen Fällen 4 - 6 µm

c: Halbtonstufenkeil mit einem Dichtewertumfang von 0,15 - 1,5 in Dichteinkrementen zu 0,15

d: Bestimmung auf den Druckbogen nach dem 1000ten Druck

e: Nach 30.000 Drucken erfolgte ein Herausbrechen der 4- bis 6-µm breiten Bildlinien.

+: und mehr

Beispiel 15 und Vergleichsbeispiele 16 und 17

Anhand der folgenden Beispiele soll gezeigt werden, daß das zweischichtige System bezüglich der Lagerstabilität gegenüber einer Monoschicht deutliche Vorteile aufweist.

Es wurden Schichten der Zusammensetzungen aus Beispiel 11 und aus den Vergleichsbeispielen 13

und 14 auf einen mit Salzsäure aufgerauhten, anodisierten und mit einer 0,1 %igen wäßrigen Lösung von Polyvinylphosphonsäure nachbehandelten Träger aufgebracht, so daß jeweils ein Trockenschichtgewicht von 1,8 g/m$^2$ erzielt wurde.

Zu jedem Beispiel wurde jeweils ein Blech eine, zwei, drei und vier Stunden in einem Umluftschrank auf 100 °C erwärmt. Nach Ablauf der Zeit wurden die Bleche herausgenommen, abgekühlt und wie in Beispiel 1 beschrieben belichtet und entwickelt. Zum Vergleich wurde zu jedem Beispiel jeweils ein nicht erhitztes Blech belichtet und entwickelt.

Es wurden folgende Ergebnisse erzielt:

| Beispiele/Vergleichsbeispiele | 15 | 16 | 17 |
|---|---|---|---|
| Trockenschichtdicke (g/m$^2$) der | | | |
| Zwischenschicht | 1,0 | 1,8 | 0,0 |
| Schicht | 0,8 | 0,0 | 1,8 |
| Gesamtschicht | 1,8 | 1,8 | 1,8 |

| Beispiele/Vergleichsbeispiele | 15 | 16 | 17 |
|---|---|---|---|
| Belichtungszeit (s) | 30 | 30 | 30 |
| 0 h 100° C: | | | |
| Volltonstufe/freie Stufe | 4/6 | 3/8 | 3/7 |
| 1 h 100° C: | | | |
| Volltonstufe/freie Stufe | 6/8 | 5/10 | 7/9 |
| 2 h 100° C: | | | |
| Volltonstufe/freie Stufe | 6/9 | 8/12 | 7/9 |
| 3 h 100° C: | | nicht auf- | Fladen |
| Volltonstufe/freie Stufe | 8/10 | entwickelbar | 8/12 |
| 4 h 100° C: | | | |
| Volltonstufe/freie Stufe | Fladen | nicht auf- | Fladen |
| | 9/12 | entwickelbar | 8/13 |
| Tonneigung | nein | stark | ja |

Beispiele 18 bis 20

Diese Beispiele entsprechen dem Beispiel 1 mit der Ausnahme, daß andere Bindemittel, d. h. andere Umsetzungsprodukte des Polyvinylbutyrals jeweils in beiden lichtempfindlichen Schichten verwendet wurden.

Beispiel 18

Anstelle des in Beispiel 1 verwendeten Bindemittels wurde in diesem Beispiel ein Umsetzungsprodukt

eines Polyvinylbutyrals mit einer OH-Zahl von 220 mit Butylisocyanat und Maleinsäureanhydrid eingesetzt. Das Umsetzungsprodukt hatte einen Stickstoffgehalt von 1,8 % und eine Säurezahl von 35.

Kopiertechnisch wurden ähnliche Ergebnisse erhalten, wie in Beispiel 1 angegeben.

Beispiel 19

In diesem Beispiel wurde ein Umsetzungsprodukt eines Polyvinylalkohols mit 5-Hydroxypentanal und Butanal eingesetzt. Das Umsetzungsprodukt hatte eine OH-Zahl von 320. Kopier- und drucktechnisch wurden ähnliche Ergebnisse erzielt, wie in Beispiel 1 angegeben.

Beispiel 20

In diesem Beispiel wurde ein Umsetzungsprodukt des in Beispiel 1 beschriebenen Polyvinylbutyrals mit Pyridin-2,3-dicarbonsäureanhydrideingesetzt. Das Umsetzungsprodukt hatte eine Säurezahl von 38. Kopier- und drucktechnisch wurden ähnliche Ergebnisse erhalten, wie in Beispiel 1 angegeben.

Beispiele 21 bis 23

Diese Beispiele entsprechen dem Beispiel 1 mit der Ausnahme, daß anstelle eines technischen Gemisches aus Pentaerythrittri- und -tetraacrylat andere ungesättigte Monomere verwendet wurden.

Beispiel 21

Verwendung von Glycerindiacrylat.

Kopier- und drucktechnisch wurden ähnliche Ergebnisse erzielt, wie in Beispiel 1 angegeben.

Beispiel 22

Verwendung eines 1 : 1 Gemisches des technischen Gemisches aus Pentaerythrittri- und -tetraacrylat mit einem urethanhaltigen Monomeren, das aus 2 mol Hydroxyethylacrylat und 1 mol 2,4-Diisocyanatotoluol hergestellt wurde. Kopier- und drucktechnisch wurden ähnliche Ergebnisse erzielt, wie in Beispiel 1 angegeben.

Beispiel 23

Verwendung eines 1 : 2 Gemisches des technischen Gemisches aus Pentaerythrittri- und -tetraacrylat mit einem urethanhaltigen Monomeren, das aus 2 mol Isocyanatoethylmethacrylat und 1 mol Diethylenglykol hergestellt wurde. Kopier- und drucktechnisch wurden ähnliche Ergebnisse erzielt, wie in Beispiel 1 angegeben.

Beispiel 24

Ein in Salzsäure elektrochemisch aufgerauhtes, anodisiertes und hydrophilisiertes Aluminiumblech wurde mit einer Mischung nachstehender Zusammensetzung beschichtet:

| | |
|---|---|
| 87,25 Gt | einer 13,0 %-igen Lösung eines Umsetzungsprodukts aus dem in Beispiel 1 beschriebenen Polyvinylbutyral mit Maleinsäureanhydrid in Ethylmethylketon (Säurezahl des Umsetzungsproduktes: 37), |
| 11,25 Gt | des in Beispiel 1 beschriebenen Diazoniumsalz-Polykondensationsprodukts, |
| 3,02 Gt | Renolblau B2G-HW (C.I. 74 160), |
| 0,52 Gt | 85 %ige Phosphorsäure und |
| 0,20 Gt | Phenylazodiphenylamin in einer Mischung aus |
| 530 Gt | Ethylenglykolmonomethylether, |
| 174 Gt | Tetrahydrofuran und |
| 70 Gt | Essigsäurebutylester. |

Das Trockenschichtgewicht wurde auf 1 g/m$^2$ eingestellt. Auf diese lichtempfindliche Schicht wurde eine zweite lichtempfindliche Schicht nachstehender Zusammensetzung aufgebracht:

| | |
|---|---|
| 95,4 Gt | der vorstehend beschriebenen Lösung des Umsetzungsprodukts, |
| 7,3 Gt | des vorstehend beschriebenen Diazoniumsalz-Polykondensationsprodukts, |

| | |
|---|---|
| 13,92 Gt | des technischen Gemischs aus Pentaerythrittri- und -tetraacrylat aus Beispiel 1, |
| 4,24 Gt | Renolblau B2G-HW (C.I. 74 160), |
| 1,29 Gt | des in Beispiel 3 beschriebenen Triazins und |
| 0,39 Gt | 85 %ige Phosphorsäure in |
| 620 Gt | Ethylenglykolmonomethylether und |
| 50 Gt | Ethylmethylketon. |

Das Trockenschichtgewicht dieser Schicht wurde auf 0,8 g/$m^2$ eingestellt.

Vier Bleche dieses zweischichtigen Systems wurden 30 Sekunden lang durch eine geeignete Negativvorlage bildmäßig belichtet und anschließend mit dem Entwickler des Beispiels 3 entwickelt. Drei der erhaltenen Druckformen wurden durch Überwischen mit einer 3 %igen wäßrigen Lösung von Polystyrolsulfonsäure (®Versa TL70 der Fa. National Starch) konserviert.

Eine dieser konservierten Druckformen wurde anschließend einer Gesamtnachbelichtung von 200 Sekunden ausgesetzt. Eine zweite dieser Druckformen wurde in einem Umluft-Trockenschrank 5 Minuten auf 230° C erhitzt.

Beide Druckplatten wurden nebeneinander in eine Bogenoffsetmaschine eingespannt. Als Druckfarbe wurde eine UV-härtbare Farbe mit hohem Lösungsmittelanteil verwendet.

Die lediglich entwickelte sowie die konservierte Platte erzielten Auflagen von über 220.000 Drucken. Die darüber hinaus nachbelichtete Platte erzielte eine Auflage von über 280.000 Drucken. Die nacherhitzte Druckplatte zeigte zu diesem Zeitpunkt noch keinerlei Abrieberscheinungen.

## Beispiel 25

Es wurden entsprechend Beispiel 24 derart Flachdruckformen hergestellt, bei denen der lichtempfindlichen Zwischenschicht 0,5 Gt 2,5-Dimethylhexan-2,5-di-tert.-butylperoxid als 45 %iges Kreidegranulat hinzugefügt wurden. Die Mischung wurde vor dem Auftragen filtriert.

Die entsprechend Beispiel 3 verarbeiteten Druckschablonen wurden mit einem handelsüblichen Konservierungsmittel konserviert und anschließend 5 Minuten auf 200° C erhitzt.

Mit einer solchen Platte wurden in einer Bogenoffsetmaschine 400.000 Drucke erzielt. Die verwendete Flachdruckform zeigte nach dieser Auflage noch keinerlei Beschädigung.

## Beispiel 26

Es wurden entsprechend Beispiel 24 Flachdruckformen hergestellt, bei denen der lichtempfindlichen Schicht 0,5 Gt des in Beispiel 25 beschriebenen Peroxids zugesetzt wurden.

Wurden die beschichteten Bleche entsprechend Beispiel 25 entwickelt, konserviert und nacherhitzt, so wurden vergleichbare Ergebnisse erzielt.

## Beispiel 27

Entsprechend Beispiel 10 beschichtete Aluminiumbleche wurden unbelichtet in einem Wärmeschrank (Hotbox) bei einer Temperatur von 56° C zwei, sechs, dreizehn und sechsundzwanzig Wochen aufbewahrt. Nach der jeweiligen Entnahme der Platten wurden diese, wie in Beispiel 3 beschrieben, belichtet und entwickelt.

Selbst die sechsundzwanzig Wochen gelagerte Platte zeigte weder in Kopie noch im Druck einen signifikanten Unterschied zu der Originalplatte des Beispiels 10. Die Lagerstabilität des Gemischs auch bei erhöhter Temperatur ist demnach ausgezeichnet.

## Beispiel 28

Entsprechend Beispiel 10 beschichtete Aluminiumbleche wurden unbelichtet in einem Tropenschrank bei einer relativen Feuchtigkeit von 60 % und einer Temperatur von 42° C eine, zwei, fünf, zehn und zwanzig Wochen aufbewahrt. Nach der jeweiligen Entnahme wurden diese, wie in Beispiel 3 beschrieben, belichtet und entwickelt.

Auch die zwanzig Wochen gelagerte Druckform zeigte weder in Kopie noch im Druck signifikante Abweichungen von der Originalplatte des Beispiel 10. Die Lagerfähigkeit des Gemischs unter Tropenbedingungen ist demnach ausgezeichnet.

## Beispiel 29

Ein in Salpetersäure elektrochemisch aufgerauhtes, anschließend anodisiertes und mit 0,1 %iger wäßriger Lösung von Polyvinylphosphonsäure nachbehandeltes Aluminiumblech wurde mit einer Mischung folgender Zusammensetzung in einer solchen Menge beschichtet, daß nach deren Trocknung ein Trockenschichtgewicht von 1,2 g/m$^2$ resultierte:

| | |
|---|---|
| 65 Gt | des Umsetzungsprodukts eines Polyvinylalkohols, dessen 4 %ige wäßrige Lösung eine Viskosität von 8 mPa•s aufwies (®Mowiol 8-88 der Fa. Hoechst AG), mit Butyral und 3-Hydroxybutyral (Molverhältnis 1 : 1) (Hydroxylzahl des Umsetzungsproduktes: 365), |
| 20 Gt | des in Beispiel 1 beschriebenen Diazoniumsalz-Polykondensationsprodukts, |
| 2,5 Gt | 85 %ige Phosphorsäure, |
| 3,3 Gt | Renolblau B2G-HW (C.I. 74 160) und |
| 0,6 Gt | Phenylazodiphenylamin in einer Mischung aus |
| 2400 Gt | Ethylenglykolmonomethylether und |
| 800 Gt | Tetrahydrofuran. |

Nach Trocknung wurde eine weitere lichtempfindliche Schicht nachstehender Zusammensetzung aufgebracht:

| | |
|---|---|
| 60 Gt | des in Beispiel 1 angegebenen Umsetzungsprodukts aus einem Polyvinylbutyral mit Maleinsäureanhydrid, |
| 18 Gt | des in Beispiel 1 beschriebenen Diazoniumsalz-Polykondensationsprodukts, |
| 3,6 Gt | Viktoriareinblau FGA (C.I. Basic Blue 81), |
| 60 Gt | eines technischen Gemisches aus Pentaerythrittri- und -tetraacrylat, |
| 4,5 Gt | des in Beispiel 1 beschriebenen Triazins und |
| 1,4 Gt | 85 %ige Phosphorsäure in einer Mischung aus |
| 2400 Gt | Ethylenglykolmonomethylether und |
| 500 Gt | Ethylmethylketon. |

Das Gemisch zeigte ein Gesamttrockenschichtgewicht von 2,3 g/m$^2$. Die Verarbeitung erfolgte, wie in Beispiel 3 angegeben.

Es wurde eine Flachdruckform mit steiler Gradation, hervorragender Wiedergabe, geringer Unterstrahlungsneigung und deutlich sichtbarem Kontrast erhalten.

Auch diese Druckform erzielte eine Auflage von mehr als 350.000 Drucken, ohne Beschädigungen zu erleiden.

Beispiel 30

Ein vorbehandeltes Aluminiumblech wurde mit einer lichtempfindlichen Lösung folgender Zusammensetzung beschichtet:

| | |
|---|---|
| 40 Gt | des Umsetzungsprodukts aus einem Polyvinylbutyral (®Mowital B60T der Fa. Hoechst AG) mit Methylisocyanat und Maleinsäureanhydrid mit einem Stickstoffgehalt von 2,1 % (Säurezahl des Umsetzungsprodukts: 28), |
| 40 Gt | des in Beispiel 1 beschriebenen Diazoniumsalz-Polykondensationsprodukts, |
| 3,2 Gt | 85 %ige Phosphorsäure, |
| 4,0 Gt | Renolkarmin-FBB-HW (C.I. Pigment Red 146) und |
| 0,6 Gt | Phenylazodiphenylamin in |
| 2500 Gt | Ethylenglykolmonomethylether. |

Das Trockenschichtgewicht dieser Mischung lag bei 0,3 g/m$^2$. Diese wurde mit der lichtempfindlichen Schicht aus Beispiel 29 beschichtet, wobei ein Gesamttrockenschichtgewicht von 2,0 g/m$^2$ resultierte.

Die violett erscheinende Flachdruckform wurde wie in Beispiel 3 beschrieben verarbeitet. Dabei ließ sich beobachten, daß bei vorsichtiger Entwicklung zunächst die Schicht mit blauer und anschließend die Unterschicht mit roter Farbe abgelöst wurde. Eine Vermischung der Schichten untereinander ist deshalb auszuschließen.

Mit der fertiggestellten Druckform ließen sich in einer Bogenoffsetmaschine mehr als 450.000 qualitativ einwandfreie Drucke erhalten.

## Patentansprüche

1. Lichtempfindliches Aufzeichnungsmaterial mit einem Schichtträger und einer lichtempfindlichen Schicht, die im wesentlichen ein Diazoniumsalz-Polykondensationsprodukt, ein in Wasser unlösliches, in organischen Lösungsmitteln lösliches und in wäßrigalkalischen Lösungen lösliches, zumindest aber quellbares polymeres Bindemittel, einen unter Einwirkung von aktinischer Strahlung Radikale bildenden

Polymerisationsinitiator und eine polymerisierbare ethylenisch ungesättigte Verbindung mit mindestens einer ungesättigten Gruppe und einem Siedepunkt bei Normaldruck oberhalb von 100° C enthält, dadurch gekennzeichnet, daß das Aufzeichnungsmaterial zwischen der lichtempfindlichen Schicht und dem Schichtträger eine lichtempfindliche Zwischenschicht enthält, die im wesentlichen ein DiazoniumsalzPolykondensationsprodukt und ein in Wasser unlösliches, in organischen Lösungsmitteln lösliches und in wäßrig-alkalischen Lösungsmitteln lösliches, zumindest aber quellbares polymeres Bindemittel enthält.

**2.** Lichtempfindliches Aufzeichnungsmaterial nach Anspruch 1, dadurch gekennzeichnet, daß die polymeren Bindemittel Hydroxyl- und/oder Carboxylgruppen enthalten.

**3.** Lichtempfindliches Aufzeichnungsmaterial nach Anspruch 1, dadurch gekennzeichnet, daß die polymeren Bindemittel Säurezahlen von 10 bis 250 und/oder Hydroxylzahlen von 100 bis 500 aufweisen.

**4.** Lichtempfindliches Aufzeichnungsmaterial nach Anspruch 1, dadurch gekennzeichnet, daß die polymeren Bindemittel im wesentlichen Umsetzungsprodukte intramolekularer Anhydride organischer Polycarbonsäuren mit Hydroxylgruppen enthaltenden Polymeren sind.

**5.** Lichtempfindliches Aufzeichnungsmaterial von Anspruch 1, dadurch gekennzeichnet, daß die polymeren Bindemittel Umsetzungsprodukte von Maleinsäureanhydrid, Phthalsäureanhydrid, Bernsteinsäureanhydrid, 3-Oxaglutarsäureanhydrid oder Pyridin-2,3-dicarbonsäureanhydrid mit Hydroxylgruppen enthaltenden Polyvinylacetalen bzw. Polyvinylacetaten sind.

**6.** Lichtempfindliches Aufzeichnungsmaterial nach einem der Ansprüche 4 und 5, dadurch gekennzeichnet, daß die polymeren Bindemittel Umsetzungsprodukte intramolekularer Anhydride von Polycarbonsäuren und aliphatischen oder aromatischen Isocyanaten mit Hydroxylgruppen enthaltenden Polymeren sind.

**7.** Lichtempfindliches Aufzeichnungsmaterial nach Anspruch 6, dadurch gekennzeichnet, daß die polymeren Bindemittel seitenständige Urethangruppen aufweisen.

**8.** Lichtempfindliches Aufzeichnungsmaterial nach Anspruch 1, dadurch gekennzeichnet, daß das Diazoniumsalz-Polykondensationsprodukt aus wiederkehrenden Einheiten $A\text{-}N_2Q$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

**9.** Lichtempfindliches Aufzeichnungsmaterial nach Anspruch 8, dadurch gekennzeichnet, daß das Diazoniumsalz-Polykondensationsprodukt ein Produkt mit wiederkehrenden Einheiten $A\text{-}N_2Q$ und B ist, die durch zweibindige, von einer kondensationsfähigen Carbonylverbindung abgeleitete Zwischenglieder verbunden sind, wobei die Einheiten $A\text{-}N_2Q$ sich aus Verbindungen der allgemeinen Formel

$$(R^8\text{-}R^9\text{-})_pR^{10}\text{-}N_2Q$$

ableiten und wobei

- Q das Anion der Diazoniumverbindung,
- p eine ganze Zahl von 1 bis 3,
- $R^8$ einen aromatischen Rest mit mindestens einer zur Kondensation mit aktiver Carbonylverbindung befähigten Position,
- $R^{10}$ eine Phenylengruppe,
- $R^9$ eine Einfachbindung oder eine der Gruppen:

$-(CH_2)_q\text{-}NR^{11}\text{-}$,
$-O\text{-}(CH_2)_r\text{-}NR^{11}\text{-}$,
$-S\text{-}(CH_2)_r\text{-}NR^{11}\text{-}$,

-S-$CH_2$CO-$NR^{11}$-,
-O-$R^{12}$-O-,
- O -
- S -

oder

-CO-$NR^{11}$-

bedeuten, worin

q eine Zahl von 0 bis 5,
r eine Zahl von 2 bis 5,
$R^{11}$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^{12}$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

**10.** Lichtempfindliches Aufzeichnungsmaterial nach Anspruch 1, dadurch gekennzeichnet, daß die polymerisierbare, ethylenisch ungesättigte Verbindung bifunktionell ist.

**11.** Lichtempfindliches Aufzeichnungsmaterial nach Anspruch 10, dadurch gekennzeichnet, daß die polymerisierbare, ethylenisch ungesättigte Verbindung ein Molekulargewicht von 300 bis 5000 aufweist.

**12.** Lichtempfindliches Aufzeichnungsmaterial nach Anspruch 1, dadurch gekennzeichnet, daß das Verhältnis der Schichtdicke der lichtempfindlichen Schicht zur lichtempfindlichen Zwischenschicht im Bereich 1:50 bis 5:1 ist.

**13.** Lichtempfindliches Aufzeichnungsmaterial nach Anspruch 1, dadurch gekennzeichnet, daß der Schichtträger aus Aluminium besteht.

**14.** Verfahren zur Herstellung eines lichtempfindlichen Aufzeichnungsmaterials nach Anspruch 1, dadurch gekennzeichnet, daß der Schichtträger mechanisch, chemisch und/oder elektrochemisch aufgerauht und anodisiert wird, daß die Beschichtung des Schichtträgers mit den beiden lichtempfindlichen Schichten aus entsprechenden organischen Lösungsmitteln oder Lösungsmittelgemischen erfolgt, wobei die lichtempfindliche Schicht erst dann aufgetragen wird, wenn die schon auf den Schichtträger aufgebrachte lichtempfindliche Zwischenschicht abgetrocknet ist, so daß diese nicht oder nur wenig angelöst wird, daß die Belichtung bildmäßig erfolgt und die Entwicklung mit einer wäßrig-alkalischen Entwicklerlösung mit einem pH-Wert von 8 bis 14 erfolgt.

**15.** Verfahren zur Herstellung eines lichtempfindlichen Aufzeichnungsmaterials nach Anspruch 14, dadurch gekennzeichnet, daß die entwickelte Druckplatte durch Erwärmen auf eine Temperatur im Bereich von 150 bis 230° C nachgehärtet wird.

**16.** Verfahren zur Herstellung eines lichtempfindlichen Aufzeichnungsmaterials nach Anspruch 15, dadurch gekennzeichnet, daß einer der lichtempfindlichen Schichten ein Pigment hinzugefügt wird, dessen mittlerer Teilchendurchmesser größer ist als die Gesamtdicke der beiden lichtempfindlichen Schichten.

**17.** Verfahren zur Herstellung eines lichtempfindlichen Aufzeichnungsmaterials nach Anspruch 15, dadurch gekennzeichnet, daß die lichtempfindlichen Schichten zunächst nacheinander auf einen temporären Schichtträger aufgetragen werden, von dem sie als Zweischichtverbund abgetrennt werden, um schließlich auf den endgültigen Schichtträger laminiert zu werden.

## Claims

**1.** A photosensitive recording material comprising a layer support and a photosensitive layer, which layer essentially comprises a diazonium salt polycondensation product, a polymeric binder which is insoluble

in water, is soluble in organic solvents and is soluble or at least swellable in aqueous-alkaline solutions, a polymerization initiator which forms free radicals when exposed to actinic radiation and a polymerizable ethylenically unsaturated compound containing at least one unsaturated group and having a boiling point at normal pressure of over 100 °C, characterized in that the recording material comprises, between the photosensitive layer and the layer support, a photosensitive intermediate layer which essentially comprises a diazonium salt polycondensation product and a polymeric binder which is insoluble in water, is soluble in organic solvents and is soluble or at least swellable in aqueous-alkaline solvents.

**2.** The photosensitive recording material as claimed in claim 1, characterized in that the polymeric binders contain hydroxyl and/or carboxyl groups.

**3.** The photosensitive recording material as claimed in claim 1, characterized in that the polymeric binders have acid numbers from 10 to 250 and/or hydroxyl numbers from 100 to 500.

**4.** The photosensitive recording material as claimed in claim 1, characterized in that the polymeric binders are essentially reaction products of intramolecular anhydrides of organic polycarboxylic acids with polymers containing hydroxyl groups.

**5.** The photosensitive recording material as claimed in claim 1, characterized in that the polymeric binders are reaction products of maleic anhydride, phtalic anhydride, succinic anhydride, 3-oxaglutaric anhydride or pyridine-2,3-dicarboxylic acid anhydride with polyvinyl acetals or polyvinyl acetates containing hydroxyl groups.

**6.** The photosensitive recording material as claimed in one of the claims 4 and 5, characterized in that the polymeric binders are reaction products of intramolecular anhydrides of polycarboxylic acids and aliphatic or aromatic isocyanates with polymers containing hydroxyl groups.

**7.** The photosensitive recording material as claimed in claim 6, characterized in that the polymeric binders have lateral urethane groups.

**8.** The photosensitive recording material as claimed in claim 1, characterized in that the diazonium salt polycondensation product is composed of repeating $A-N_2Q$ and B units which are joined to each other by intermediate links, preferably methylene groups, which are derived from carbonyl compounds which can be condensed, A being the radical of an aromatic diazonium compound which can be condensed with formaldehyde and B being the radical of a compound which is free of diazonium groups and can be condensed with formaldehyde, in particular, of an aromatic amine, of a phenol, of a phenol ether, of an aromatic thioether, of an aromatic hydrocarbon, of an aromatic heterocyclic compound or of an organic acid amide.

**9.** The photosensitive recording material as claimed in claim 8, characterized in that the diazonium salt polycondensation product is a product with repeating $A-N_2Q$ and B units which are joined by intermediate links with double bonds derived from a carbonyl compound which is capable of condensation, the $A-N_2Q$ units being derived from compounds of the formula

$$(R^8-R^9-)_pR^{10}-N_2Q$$

where

- Q denotes the anion of the diazonium compound,
- p denotes an integer from 1 to 3,
- $R^8$ denotes an aromatic radical having at least one position capable of condensation with an active carbonyl compound,
- $R^{10}$ denotes a phenylene group,
- $R^9$ denotes a single bond or one of the groups:

$-(CH_2)_q-NR^{11}-$,
$-O-(CH_2)_r-NR^{11}-$,
$-S-(CH_2)_r-NR^{11}-$,

$-S-CH_2CO-NR^{11}-$,
$-O-R^{12}-O-$,
- O -

or

- S -
$-CO-NR^{11}-$

where

q is a number from 0 to 5,
r is a number from 2 to 5,
$R^{11}$ is hydrogen, an alkyl group containing 1 to 5 carbon atoms, an aralkyl group containing 7 to 12 carbon atoms or an aryl group containing 6 to 12 carbon atoms, and
$R^{12}$ is an arylene group containing 6 to 12 carbon atoms,

and

B denotes the radical, which is free of diazonium groups, of an aromatic amine, of a phenol, of a thiophenol, of a phenol ether, of an aromatic thioether, of an aromatic hydrocarbon, of an aromatic heterocyclic compound or of an organic acid amide.

**10.** The photosensitive recording material as claimed in claim 1, characterized in that the polymerizable, ethylenically unsaturated compound is bifunctional.

**11.** The photosensitive recording material as claimed in claim 10, characterized in that the polymerizable, ethylenically unsaturated compound has a molecular weight of 300 to 5,000.

**12.** The photosensitive recording material as claimed in claim 1, characterized in that the ratio of the layer thickness of the photosensitive layer to the photosensitive intermediate layer is in the range of 1:50 to 5:1.

**13.** The photosensitive recording material as claimed in claim 1, characterized in that the layer support is comprised of aluminum.

**14.** A process for preparing a photosensitive recording material as claimed in claim 1, characterized in that the layer support is grained mechanically, chemically and/or electrochemically and is anodized, the layer suppport is coated with the two photosensitive layers from suitable organic solvents or solvent mixtures, the photosensitive layer not being applied before the photosensitive intermediate layer already applied to the layer support has dried so that the latter is not, or only slightly, incipiently dissolved, the layer is exposed imagewise and then developed with an aqueous-alkaline developer having a pH of 8 to 14.

**15.** The process for preparing a photosensitive recording material as claimed in claim 14, characterized in that the developed printing plate is postcured by heating at a temperature in the range from 150 to 230 °C.

**16.** The process for preparing a photosensitive recording material as claimed in claim 15, characterized in that a pigment whose mean particle size is greater than the total thickness of the two photosensitive layers is added to one of the photosensitive layers.

**17.** The process for preparing a photosensitive recording material as claimed in claim 15, characterized in that the photosensitive layers are first applied consecutively to a temporary layer support from which they are separated as a two-layer composite in order, finally, to be laminated onto the final layer support.

## Revendications

**1.** Matériau de reprographie photosensible comportant un support de couches et une couche photosensible qui contient essentiellement un produit de polycondensation de sel de diazonium, un liant polymère

insoluble dans l'eau, soluble dans des solvants organiques et soluble ou au moins susceptible de gonfler dans des solutions aqueuses-alcalines, un initiateur de polymérisation formant des radicaux sous l'effet d'un rayonnement actinique, et un composé polymérisable à insaturation éthylénique, comportant au moins un groupe insaturé et ayant un point d'ébullition supérieur à 100°C sous la pression normale, caractérisé en ce que le matériau de reprographie contient, entre la couche photosensible et le support de couches, une couche intermédiaire photosensible qui contient essentiellement un produit de polycondensation de sel de diazonium et un liant polymère insoluble dans l'eau, soluble dans des solvants organiques et soluble ou au moins susceptible de gonfler dans des solutions aqueuses-alcalines.

2. Matériau de reprographie photosensible selon la revendication 1, caractérisé en ce que les liants polymères contiennent des groupes hydroxy et/ou carboxy.

3. Matériau de reprographie photosensible selon la revendication 1, caractérisé en ce que les liants polymères présentent des indices d'acide de 10 à 250 et/ou des indices d'hydroxy de 100 à 500.

4. Matériau de reprographie photosensible selon la revendication 1, caractérisé en ce que les liants polymères sont essentiellement des produits de réaction d'anhydrides intramoléculaires d'acides polycarboxyliques organiques avec des polymères contenant des groupes hydroxy.

5. Matériau de reprographie photosensible de la revendication 1, caractérisé en ce que les liants polymères sont des produits de réaction de l'anhydride maléique, l'anhydride phtalique, l'anhydride succinique, l'anhydride 3-oxoglutarique ou l'anhydride pyridine-2,3-dicarboxylique avec des poly(acétal de vinyle)s ou des poly(acétate de vinyle)s contenant des groupes hydroxy.

6. Matériau de reprographie photosensible selon les revendications 4 et 5, caractérisé en ce que les liants polymères sont des produits de réaction d'anhydrides intramoléculaires d'acides polycarboxyliques et d'isocyanates aliphatiques ou aromatiques avec des polymères contenant des groupes hydroxy.

7. Matériau de reprographie photosensible selon la revendication 6, caractérisé en ce que les liants polymères comportent des groupes uréthanne latéraux.

8. Matériau de reprographie photosensible selon la revendication 1, caractérisé en ce que le produit de polycondensation de sel de diazonium est constitué de motifs répétitifs $A\text{-}N_2Q$ et B qui sont reliés les uns aux autres par des chaînons intermédiaires, de préférence des groupes méthylène, qui proviennent de composés carbonyle condensables, A étant le reste d'un composé diazonium aromatique condensable avec le formaldéhyde et B étant le reste d'un composé exempt de groupes diazonium, condensable avec le formaldéhyde, en particulier d'une amine aromatique, d'un phénol, phénoléther, thioéther aromatique, d'un hydrocarbure aromatique, d'un composé hétérocyclique aromatique ou d'un amide organique.

9. Matériau de reprographie photosensible selon la revendication 8, caractérisé en ce que le produit de polycondensation de sel de diazonium est un produit comportant des motifs répétitifs $A\text{-}N_2Q$ et B qui sont reliés par des chaînons intermédiaires bivalents dérivés d'un composé carbonyle condensable, les motifs $A\text{-}N_2Q$ provenant de composés de formule générale

$(R^8\text{-}R^9\text{-})_pR^{10}\text{-}N_2Q$

et dans laquelle

- Q représente l'anion du composé diazonium,
- p est un nombre entier allant de 1 à 3,
- $R^8$ représente un radical aromatique comportant au moins une position susceptible de condensation avec un composé carbonyle actif,
- $R^{10}$ représente le groupe phénylène,
- $R^9$ représente une simple liaison ou l'un des groupes:

$-(CH_2)_q\text{-}NR^{11}\text{-}$,
$-O\text{-}(CH_2)_r\text{-}NR^{11}\text{-}$,

$-S-(CH_2)_r-NR^{11}-$,
$-S-CH_2CO-NR^{11}-$,
$-O-R^{12}-O-$,
-O-,
-S-

ou

$-CO-NR^{11}-$

q étant un nombre allant de 0 à 5,
r étant un nombre allant de 2 à 5,
$R^{11}$ représentant un groupe alkyle ayant de 1 à 5 atomes de carbone, un groupe aralkyle ayant de 7 à 12 atomes de carbone ou un groupe aryle ayant de 6 à 12 atomes de carbone, et
$R^{12}$ étant un groupe arylène ayant de 6 à 12 atomes de carbone, et
B représentant le reste, exempt de groupes diazonium, d'une amine aromatique, d'un phénol, thiophénol, phénoléther, thioéther aromatique, hydrocarbure aromatique, d'un composé hétérocyclique aromatique ou d'un amide organique.

**10.** Matériau de reprographie photosensible selon la revendication 1, caractérisé en ce que le composé polymérisable, à insaturation éthylénique, est bifonctionnel.

**11.** Matériau de reprographie photosensible selon la revendication 10, caractérisé en ce que le composé polymérisable, à insaturation éthylénique, présente une masse moléculaire de 300 à 5 000.

**12.** Matériau de reprographie photosensible selon la revendication 1, caractérisé en ce que le rapport de l'épaisseur de la couche photosensible à celle de la couche intermédiaire photosensible est dans la plage de 1:50 à 5:1.

**13.** Matériau de reprographie photosensible selon la revendication 1, caractérisé en ce que le support de couches est constitué d'aluminium.

**14.** Procédé pour la préparation d'un matériau de reprographie photosensible selon la revendication 1, caractérisé en ce que le support de couches est grainé mécaniquement, chimiquement et/ou électrochimiquement et anodisé, en ce que le revêtement du support de couches avec les deux couches photosensibles est effectué à partir de solvants ou mélanges de solvants organiques appropriés, la couche photosensible n'étant appliquée qu'après séchage de la couche intermédiaire photosensible déjà appliquée sur le support de couches, de sorte que celle-ci n'est pas ou n'est que très peu dissoute, en ce que l'on effectue l'insolation selon une image et on effectue le développement à l'aide d'une solution de développement aqueuse-alcaline ayant un pH de 8 à 14.

**15.** Procédé pour la préparation d'un matériau de reprographie photosensible selon la revendication 14, caractérisé en ce que la plaque d'impression développée est soumise à un postdurcissement par chauffage à une température dans la plage de 150 à 230 °C.

**16.** Procédé pour la préparation d'un matériau de reprographie photosensible selon la revendication 15, caractérisé en ce que l'on ajoute à l'une des couches photosensibles un pigment dont la taille moyenne de particules est supérieure à l'épaisseur totale des deux couches photosensibles.

**17.** Procédé pour la préparation d'un matériau de reprographie photosensible selon la revendication 15, caractérisé en ce que les couches photosensibles sont d'abord appliquées l'une après l'autre sur un support de couches temporaire, duquel elles seront séparées, sous forme de composite bicouche, pour être finalement appliquées par laminage sur le support de couches final.